(19) Europäisches Patentamt
European Patent Office
Office européen des brevets

(11) EP 3 982 432 A1

(12) # EUROPEAN PATENT APPLICATION

(43) Date of publication:
**13.04.2022 Bulletin 2022/15**

(21) Application number: **20201128.4**

(22) Date of filing: **09.10.2020**

(51) International Patent Classification (IPC):
***H01L 51/00*** *(2006.01)* ***C09B 3/02*** *(2006.01)*

(52) Cooperative Patent Classification (CPC):
**H01L 51/0072; C09B 3/10; H01L 51/0052; H01L 51/0071;** H01L 51/0558; H01L 51/5012; H01L 51/5072

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Kaunas University of Technology**
**44249 Kaunas (LT)**

(72) Inventors:
- **Tsiko, Uliana**
**44249 Kaunas (LT)**
- **Volyniuk, Dmytro**
**44249 Kaunas (LT)**
- **Keruckiene, Rasa**
**44249 Kaunas (LT)**
- **Grazulevicius, Juozas Vidas**
**44249 Kaunas (LT)**
- **Sych, Galyna**
**44249 Kaunas (LT)**
- **Simokaitiene, Jurate**
**44249 Kaunas (LT)**
- **Keruckas, Jonas**
**44249 Kaunas (LT)**
- **Cekaviciute, Monika**
**44249 Kaunas (LT)**
- **Bezvikonnyi, Oleksandr**
**44249 Kaunas (LT)**
- **Andruleviciene, Viktorija**
**44249 Kaunas (LT)**
- **Jatautiene, Egle**
**44249 Kaunas (LT)**
- **Tan, Xiaofeng**
**44249 Kaunas (LT)**

(74) Representative: **Petniunaite, Jurga**
**AAA Law**
**P.O. Box 33**
**A. Gostauto street 40B**
**03163 Vilnius (LT)**

(54) **ORGANIC MOLECULAR MATERIALS BASED ON BENZANTHRONE ACCEPTOR MOIETY FOR OPTOELECTRONIC DEVICES**

(57) The present invention relates to organic bipolar light-emitting compounds of the general formula (I) based on benzanthrone moiety. The present invention relates to organic bipolar light-emitting benzanthrone-based compounds for optoelectronic devices, organic light-emitting diodes (OLED), light-emitting field-effect transistors (FET), light-emitting vertical transistors (VOLET), optical sensors, memory devices, data storage devices, external stress responsible probes, bio-surface-imaging probes, but is not limiting by those examples of potential applications of the present invention.



Printed by Jouve, 75001 PARIS (FR)

## Description

### FIELD OF THE INVENTION

The present invention relates to organic bipolar light-emitting benzanthrone-based compounds for optoelectronic devices, organic light-emitting diodes (OLED), light-emitting field-effect transistors (FET), light-emitting vertical transistors (VOLET), optical sensors, memory devices, data storage devices, external stress responsible probes, bio-, surface-imaging probes.

### BACKGROUND OF THE INVENTION

The development of efficient electroactive organic compounds is a prerequisite for the fabrication of highly efficient OLEDs and other optoelectronic devices. Despite the significant research efforts devoted to find easily synthesizable and efficient organic materials, molecular design still consists of complex synthesis pathways that are technologically complicated to implement (Nat. Photon. 2014, 8, 326-332, ACS Appl. Mater. Interfaces, 2016, 8, 23190-23196). The synthetic process is usually lengthy multi-step, time-consuming and expensive.

Conventional OLED materials are organometallic complexes with expensive metals such as ruthenium and iridium. The search for purely organic and yet comparatively efficient emitters as the alternatives to metal-containing OLED materials have attracted tremendous attention. As such, the discovery and application of novel strategies to increase internal quantum efficiency is essential for improving the energy efficiency of OLED. A combination of donor and acceptor moieties in a single molecule enables to obtain efficient light-emitting materials exhibiting useful phenomena such as intramolecular and intermolecular (exciplex-based) thermally activated delayed fluorescence (TADF), room temperature phosphorescence (RTP), triplet-triplet annihilation, etc. which allows harvesting of triplet excitons formed under electrical excitation and converts them into light (Nano Lett., 2015, 15, 6332-6338, Chem. Rev., 2015, 115, 11718-11940, J. Phys. Chem. C, 2015, 119, 26283-26289). The utilization of TADF effect in the active layers of OLEDs has opened wide possibilities in the search for new efficient OLED materials (Angew. Chemie Int. Ed., 2014, 53, 6402-6406). Organic donor-acceptor (D-A) semiconductors as functional materials have great potential to be practically applied in devices of optoelectronics (e.g. organic light emitting diodes (OLEDs), organic lasers, sensors, light-emitting transistors, memory cells). Properly designed D-A materials exhibit TADF and/or bipolar charge transport with balanced hole and electron mobilities that both characteristics allow to overcome energy losses in modern optoelectronic devices (Nat. Mater. 14 (2015) 459-462; Adv. Mater. 2017, 1605444-1-1605444-54). TADF and bipolar charge-transporting materials have found wide applications mainly as emitters and hosts in organic light emitting diodes (OLEDs) which have entered the global display and lighting markets due to the competitiveness and environmental reasons. 75% of triplet excitons formed under electrical excitation and which are lost in fluorescent OLEDs, can be harvested to light OLEDs based on heavy-metal-free fluorescent emitters exhibiting TADF. External quantum efficiencies (EQEs) of OLEDs based on organic low-molar-mass compounds increased steadily in recent years (Nature Reviews Materials, 2018, 3, 18020). Nevertheless, the demand of flexible molecular design, good electrochemical stability of compounds, morphological stability of active layers and well-controlled photophysical characteristics of organic emissive compounds remain relevant.

Since Adachi reported a donor-acceptor type TADF material that allows for capturing triplet state formed under electrical excitation in device structures [Nature, 2012, 492, 7428], TADF materials as emitters or hosts are successfully used in OLEDs achieving 100% of internal quantum efficiency (Nat. Commun. 2015, 6, 8476). The record values of maximum EQE for blue, green and red TADF OLEDs based on low-molar-mass emitters reached 37, 30.5 and 24.3 %, respectively (Chem. Mater., 2017, 29 (5), 1946; Adv. Mater. 2018, 30, 1704961). Huge number of TADF materials emitting in visible spectral region were invented up to now (US2018/0016493; US2019/0378977; WO2015/121241; WO2016/108046). Those organic compounds contain donor(s) and acceptor(s) in their molecular structure (Adv. Mater. 2017, 1605444-1-1605444-54). Some of D-A compounds were characterized by both efficient TADF in visible spectral region and bipolar charge transport. While examples of all-organic donor-acceptor compounds exhibiting long-lived emission (preferably TADF) in near infrared region and bipolar charge transport is very limited (Nature Photonics 2018, 12, 98-104). We predicted that combinations of planar moieties with strong electron-donating and electron-accepting abilities can result in both near infrared long-lived emission and bipolar charge transport. The benzanthrone moiety is characterized by planar molecular structure and relatively strong electron-accepting ability, thus is a good candidate for design of bipolar organic light-emitting semiconductors emitting in infrared region of electromagnetic spectra.

Donor-acceptor bipolar organic semiconductors can be used not only in OLEDs but in various other optoelectronic devices such as organic vertical light-emitting phototransistor, organic phototransistor, organic or hybrid solar cells, organic photodetectors, organic optical sensors etc.

Light-emitting properties of organic donor-acceptor emitters can be changed under external stimulus such as mechanical stimulus. Changes of light-emitting properties of such compounds can be related to changes of position

(dihedral angle) of donor in comparison to acceptor position during an externally-induced solid-state transition of crystalline to amorphous phase, for example. Thus, luminescence which usually resulted from recombination of exited intramolecular charge transfer energy states for donor-acceptor molecules may be changed. Mechano-chromic (thermoschromic, piezo-chromic, chemo-chromic, etc.) abilities of organic donor-acceptor emitters can be used for constrictions of optical sensors. Substituted by appropriate donor(s) benzanthrone derivatives expectedly can be good candidates as active materials for organic optical sensors.

In case of application of optical sensors (or OLEDs and other optoelectronic devices and probes) for diagnostic of biological analysts, there are domains of the visible and infrared spectrum showing low-attenuation of wavelengths, named transmission (optical) windows in which the radiation can be transmitted through water situated approximately from 650 to 1200 nm. It is explained by the fact that the human body is composed mostly from water, therefore its attenuation is a good approximation for the signal coming in and out the human tissue. Emission of the ca. 650-1200 nm range can penetrate biological tissues such as skin and blood more efficiently than visible light because these tissues scatter and absorb less light at longer wavelengths. One of the most important problems associated with active materials refers to the absorption of the emission in human tissue where the optical sensor is placed (e.g. the finger). Transmission through the human tissue and the absorption specific for the biological components of interest are essential in the selection of the emission radiation of OLED and in consequence of the organic compounds (emitters) used to make the OLED structure.

Resources of hydrocarbon fuels in the world rapidly decrease. Moreover, utilization of oil and gas results in the increase of average temperature of atmosphere, thus causing global warming and damaging the climate of the planet. The solution of this problem may lay in the implementation of the renewable and environmentally friendly energy sources such as wind-generated energy, hydro-generated energy and especially solar-generated energy. While water energy and wind energy have their evident drawbacks such location dependence and production cost, solar-based energy sources are flexible, efficient, versatile, and comparably inexpensive. During the last years, scientific interest in organic and/or hybrid solar cells significantly increased. However, this promising technology still has some drawbacks which can be avoided by careful research. Organic semiconductors with simplified and inexpensive synthesis are required for efficient organic and/or hybrid solar cells. Those organic semiconductors should be characterized by high charge mobilities and preferably narrow bandgap, thus absorption in near infrared region. Absorption related to intramolecular charge transfer in ground state between strong donor and strong acceptor moieties may reach infrared region when those donor and acceptor are appropriately selected. Expectedly, benzanthrone moiety is the right acceptor.

## SUMMARY OF THE INVENTION

Our present invention is related to donor-acceptor organic compounds containing benzanthrone moiety(ies) as an acceptor. When the donating abilities of donors is appropriate, either bipolar-charge transport, long-lived infrared emission, mechanoresponsive luminescence, or external chemo-sensitive (at least oxygen-sensitive) luminescence can be obtained of the invented derivatives of benzanthrone.

The present invention is related to organic compounds used for optoelectronic devices, to novel emitters and light-emitting materials comprising such compounds, to optoelectronic devices comprising such emissive materials or emissive compounds, and particularly to organic light-emitting diodes (OLEDs) or light-emitting transistors (OLETs). The invention also concerns a method of preparation of such organic emissive materials, fabrication of their layers and optoelectronic devices.

The invention pursues to provide efficient organic materials consisting of an acceptor fragment, benzanthrone, which can be prepared from commercially available reagents.

The purpose of the current invention is to provide new emissive organic compounds, which have novel acceptor unit, benzanthrone, in their structure. The present invention also pursues to provide new emissive materials with effective emission properties and with suitable energy levels.

Said purpose is achieved by the entirety of features below.

The main object of the proposed invention is bipolar organic light-emitting semiconductors containing benzanthrone according to general formula (I):

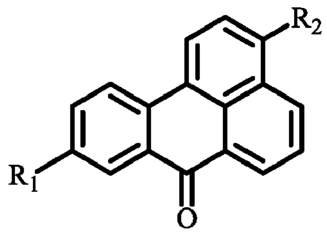

wherein $R_1$ and/ or $R_2$ is a mono- or polycyclic system comprising at least one pair of a conjugated double bond (-C=C-), the polycyclic system comprising fused aromatic rings or monocyclic aromatic rings bound together by covalent bond or heteroaromatic system with N, O, S, Se, Si B, heteroatoms. Said mono-polycyclic system being substituted by H, halogen, cyano group, C1-C20 cyanoalkyl group, C1-C20 alkyl, C1-C20 alkoxy group, C1-C20 alkoxyalkyl, C1-C20 haloalkyl group, C1-C20 haloalkoxyalkyl, wherein said cyanoalkyl, alkyl, alkoxy, alkoxyalkyl, haloalkyl, haloalkoxyalkyl, C4-C20 alkylaryl, C4-C20 alkoxyaryl C4-C20 alkenylarylalkyl, C4-C20 alkoxyarylalkenyl, C4-C20 bisalkoxyarylaalkenyl groups if they comprise 3 or more carbons, may be linear, branched or cyclic, and wherein halogen is selected from Cl, F, Br, or I.

## BRIEF DESCRIPTION OF FIGURES

**Figure 1.** Photoluminescence (PL) of compounds of formula (1-6) in dilute toluene solutions ($0.5\text{-}5\times10^{-5}$ mol $L^{-1}$) under excitation of 350 nm.

**Figure 2.** PL decays of compounds of formula (1-6) in solid state at their PL maximum under excitation of 374 nm. Solid state means neat films (for compound 6) or doped films using hosts ZEONEX (for compounds 2, 3, and 5 (1 wt.%)) or 1,3-bis(N-carbazolyl)benzene (mCP) (for compounds 1 and 4 (10 wt.%)).

**Figure 3.** Normalized PL spectra and of initial, ground, and melted states of compound ***1*** ($\lambda_{exc}$ = 330 nm) and photographs of its different states.

## DETAILED DESCRIPTION OF THE INVENTION

It has now been expectedly proven that the compounds of the formula (I) are of potential properties for use in optoelectronic components, precisely as emitter, host, sensing, imaging material or other various optical probes depending on further embodiments of the benzanthrone-based compounds of general formula (I). The compounds of the formula (I) are prominent for their hole and electron transport and long-lived emission in infrared region. Long-lived infrared emission of the compounds of the formula (I) result from reverse intersystem crossing between excited triplet energy levels to the excited singlet energy levels. This process can induce the energy conversion in electroluminescent devices theoretically up to 100 %. Long-lived infrared emission of the benzanthrone-based compounds of the formula (I) may be sensitive to external stimulus making them suitable for optical sensor applications. The benzanthrone-based compounds of the formula (I) with high charge mobilities and absorption covering optical and/or near infrared regions may be used for diode-based and/or transistor-based photodetectors or organic or hybrid solar cells.

*General synthesis scheme of compounds of general formula (I)*

Benzanthrone-based materials with donor-acceptor and donor-acceptor-donor structures corresponding to general formula (I) were synthesized *via* Buchwald-Hartwig cross coupling reaction by using 3-bromo-7*H*-benzo[*de*]anthracen-7-one (benzanthrone, Fluorochem) or 3,6-dibromo-7*H*-benzo(*de*)anthracen-7-one (Sigma-Aldrich) as acceptor, tris(dibenzylideneacetone)dipalladium(0) (Sigma-Aldrich), sodium *tert*-butoxide (Sigma-Aldrich), 2-dicyclohexylphosphino-2',4',6'-triisopropylbiphenyl (Sigma-Aldrich) and different donors such as 9*H*-carbazole (Sigma-Aldrich), 3,6-di-*tert*-butyl-9*H*-carbazole (was obtained by Friedel-Crafts reaction, [Chem. Ber. Vol. 105, 1972, 2686-93]), 10*H*-phenothiazine (Sigma-Aldrich) and 10*H*-phenoxazine (Sigma-Aldrich). These starting materials were used for synthesis of compounds **1-3** (Scheme 1) and compounds **4-6** (Scheme 2). The obtained compounds were purified by column chromatography on silica gel using different eluent mixture and recrystallized from methanol.

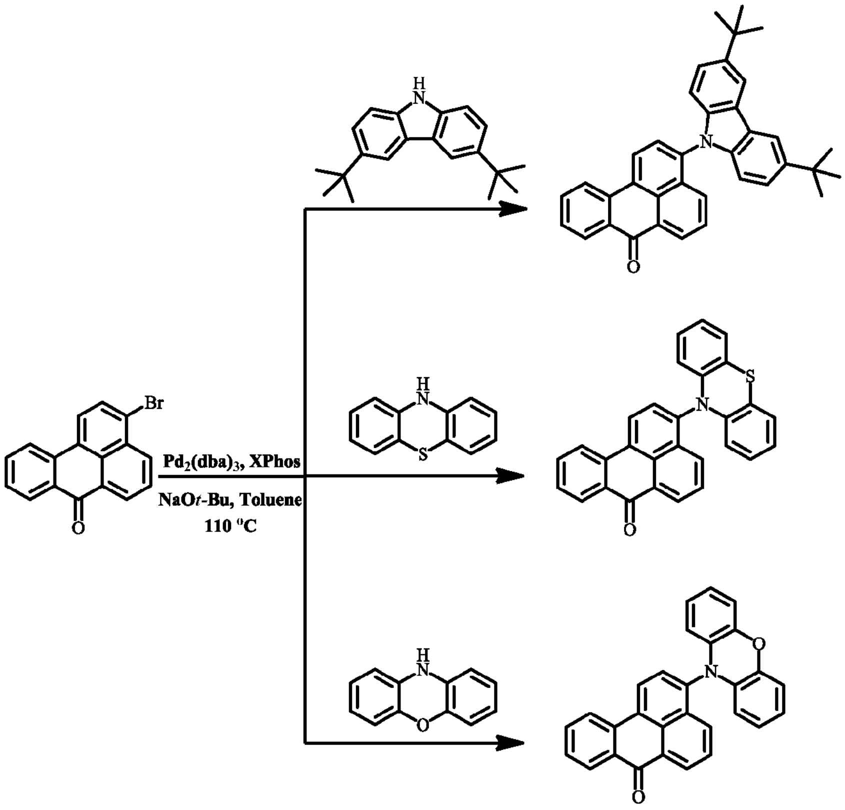


1

2

3

**Scheme 1.** Synthesis route of compounds **1-3**

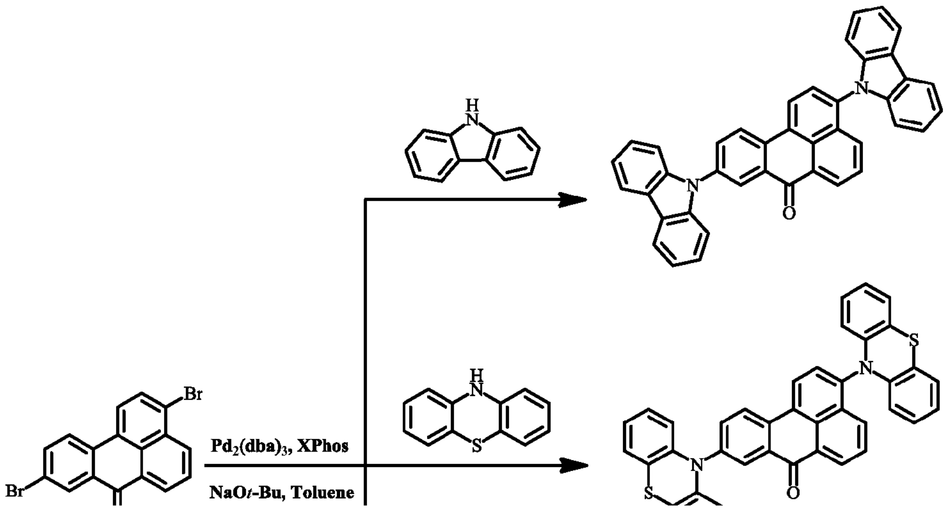


4

5

**Scheme 2.** Synthesis route of compounds **4-6**

According to a further embodiment, the bipolar organic light-emitting semiconductors containing benzanthrone of formula (I) is selected from, but not limited to, a compound according to any one of formulae (1) to (70):

***Donor-acceptor (D-A) structure***

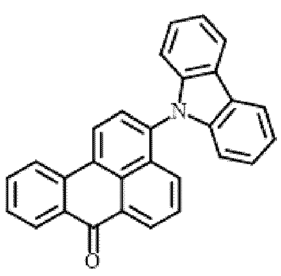

1

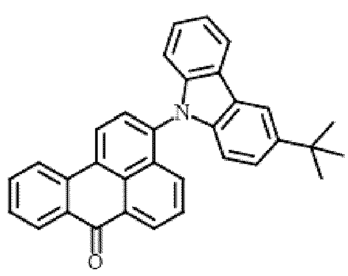

2

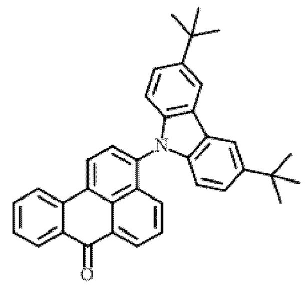

3

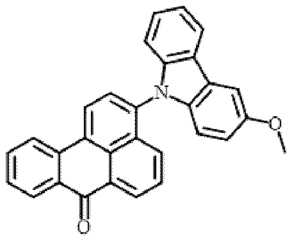

4

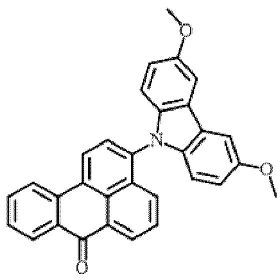

5

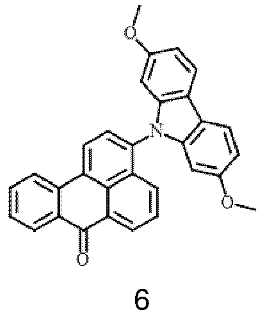

6

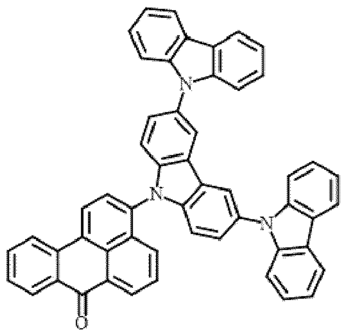

7

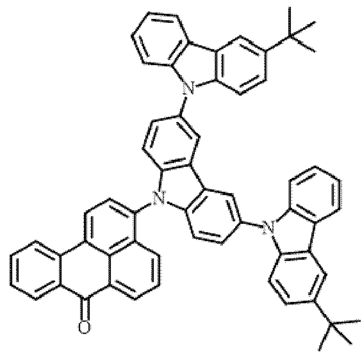

8

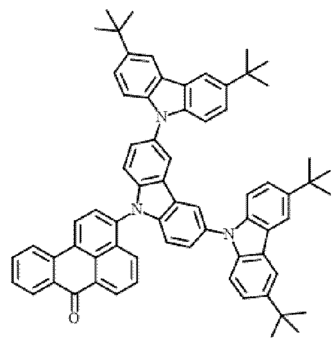

9

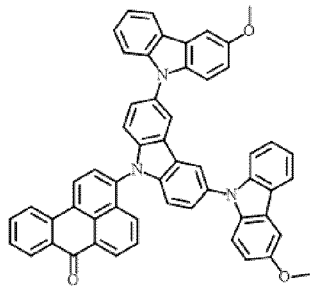

10

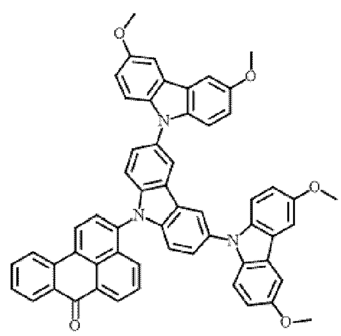

11

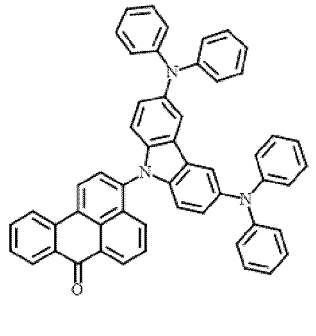

12

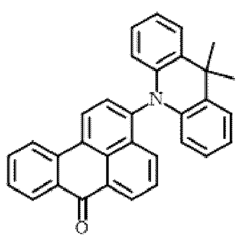

13

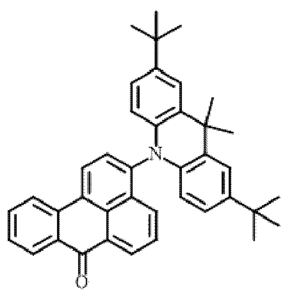

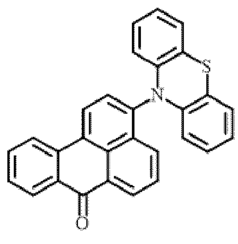

15

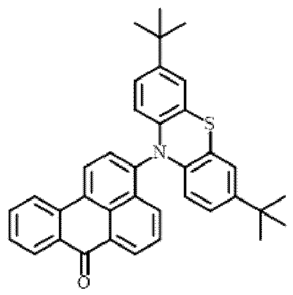

16

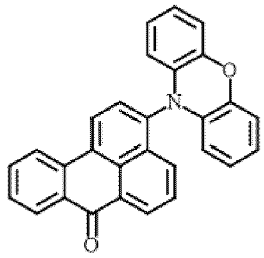

17

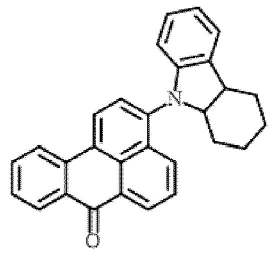

18

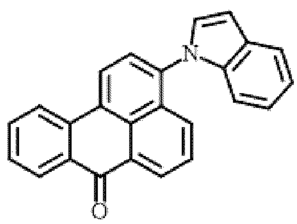

19

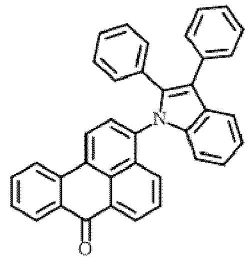

20

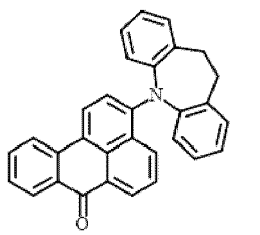

21

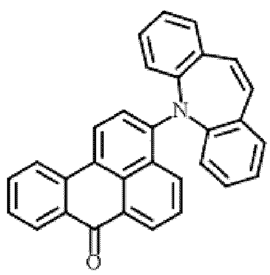

22

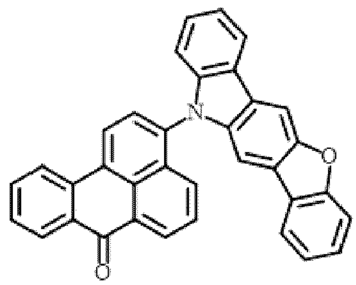

23

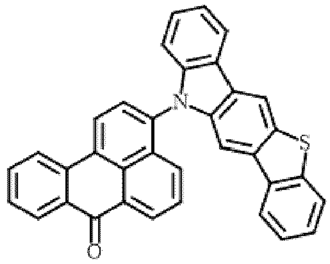

24

***Donor-acceptor-donor (D-A-D) structure***

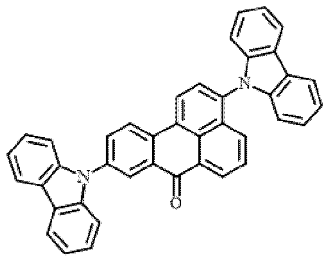

25

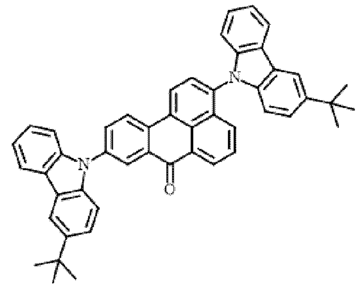

26

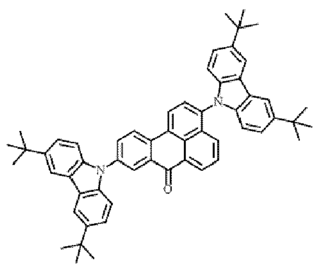

27

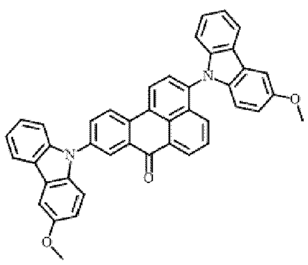

28

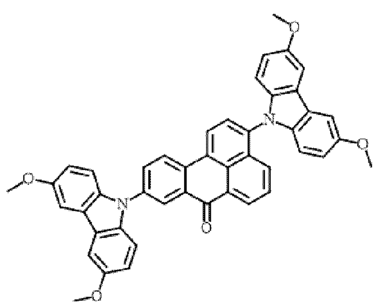

29

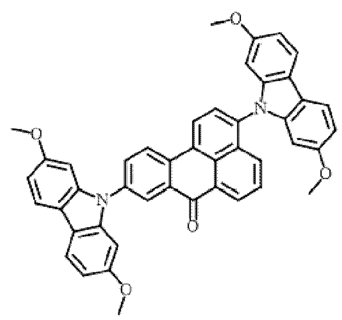

30

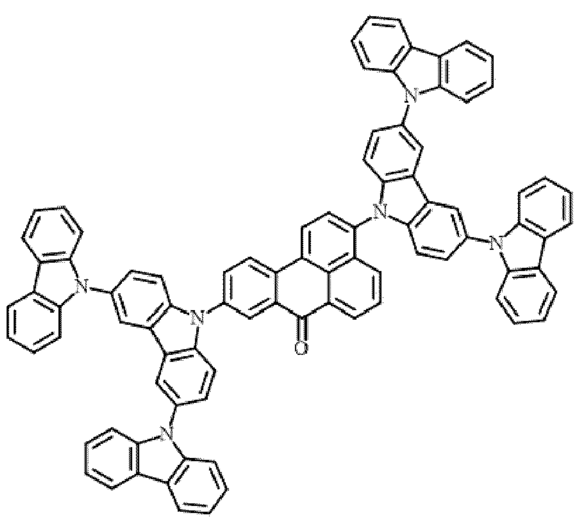

31

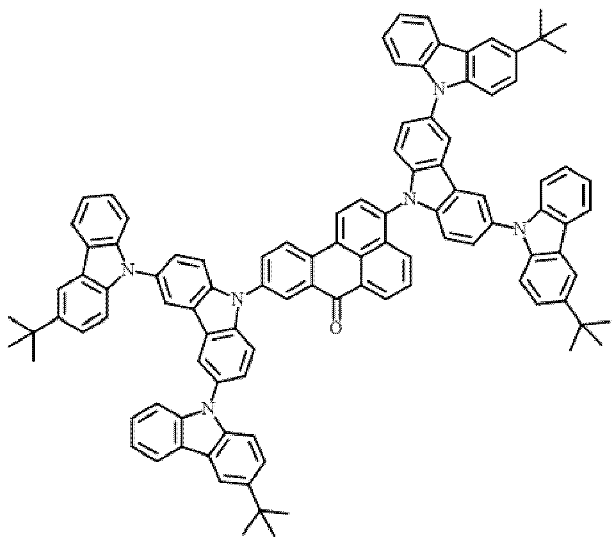

32

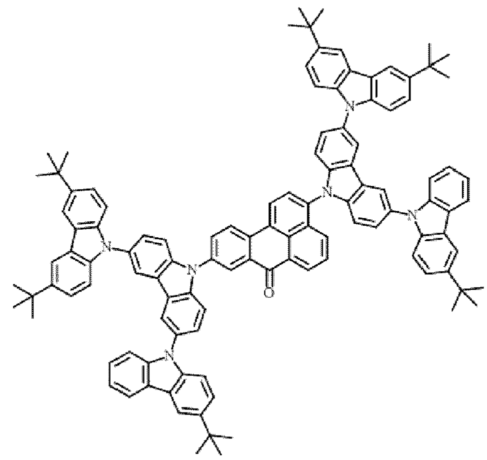

33

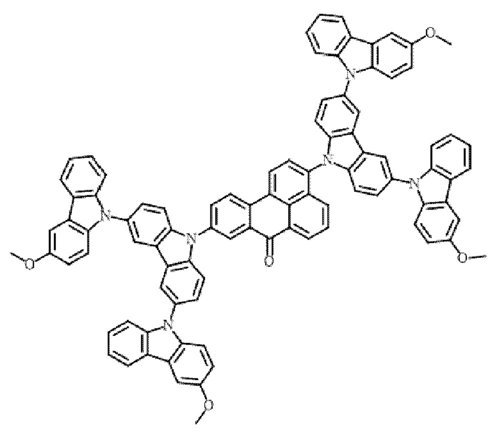

34

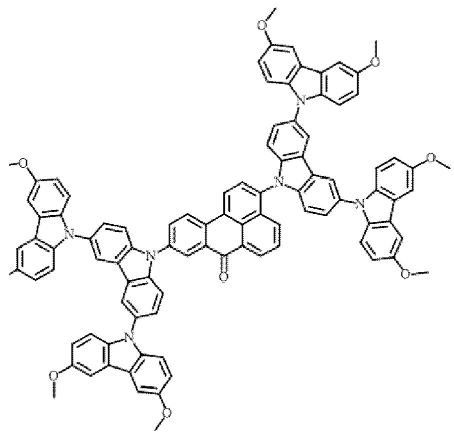

35

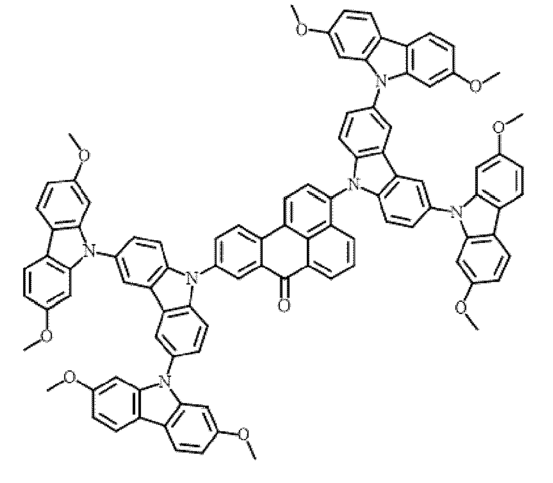

36

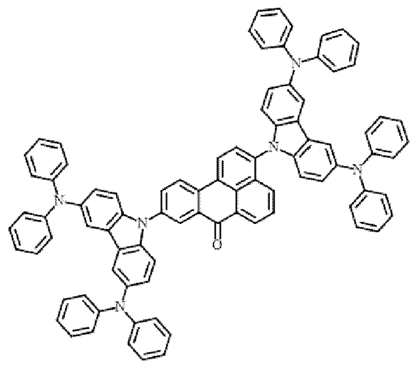

37

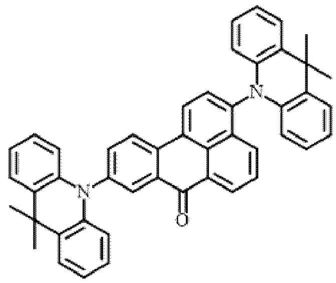

38

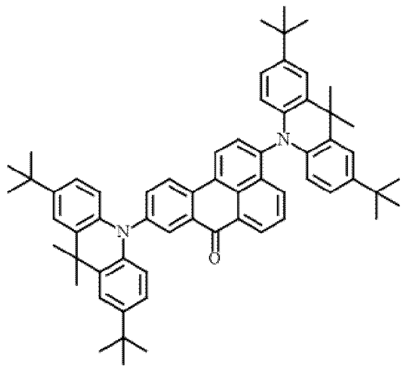

39

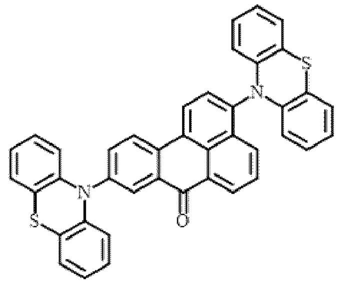

40

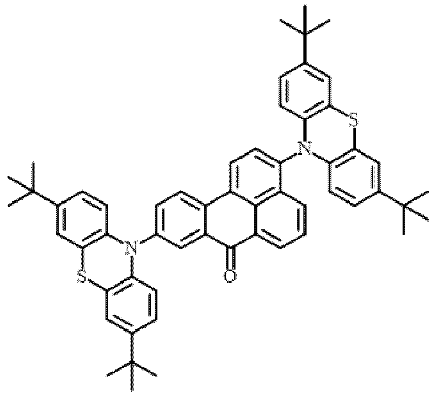

41

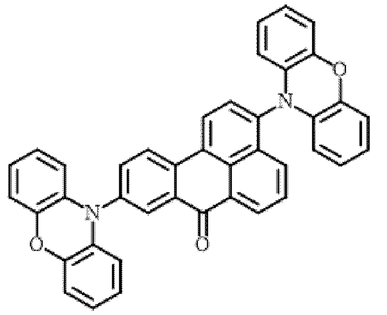

42

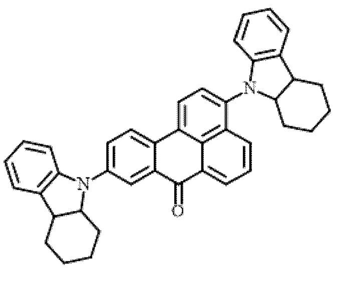

43

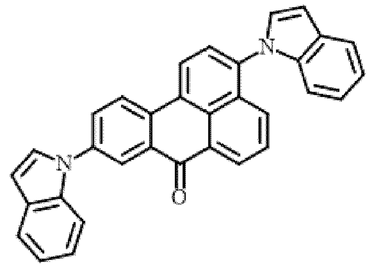

44

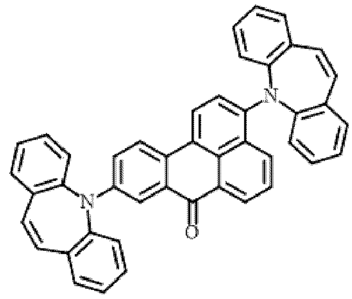

45

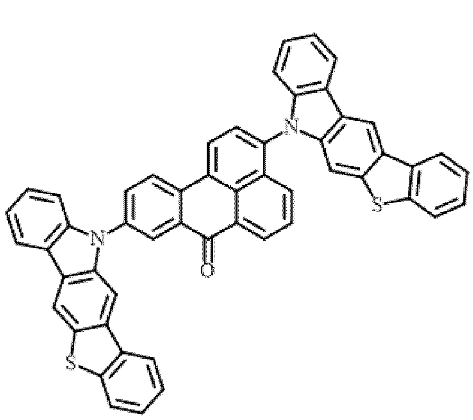

46

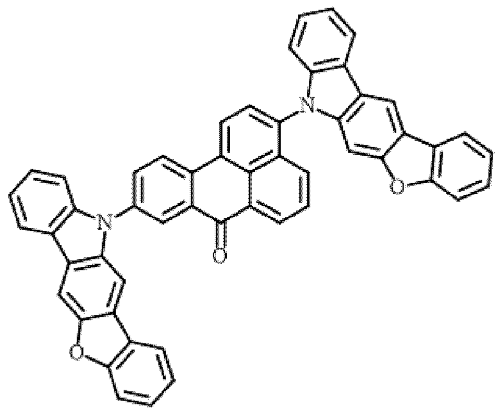

47

***Asymmetric donor-acceptor-donor' (D-A-D') structure***

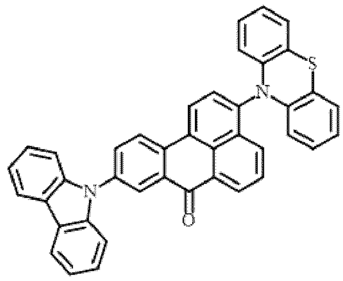

48

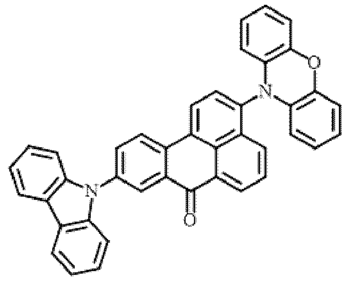

49

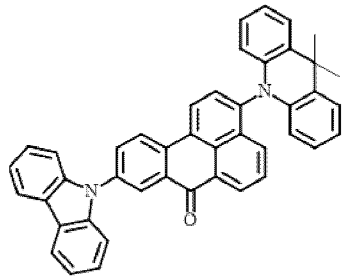

50

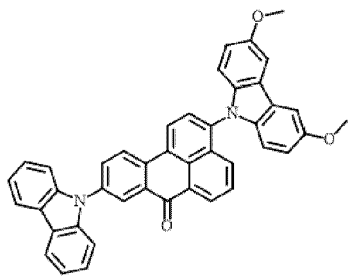

51

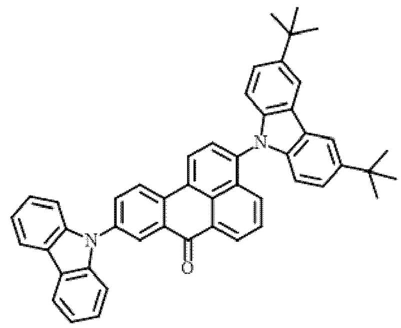

52

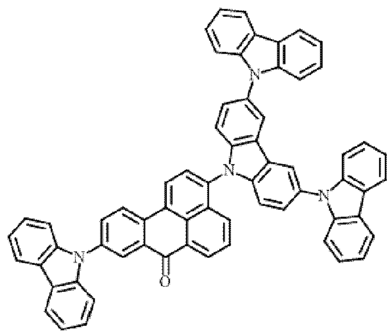

53

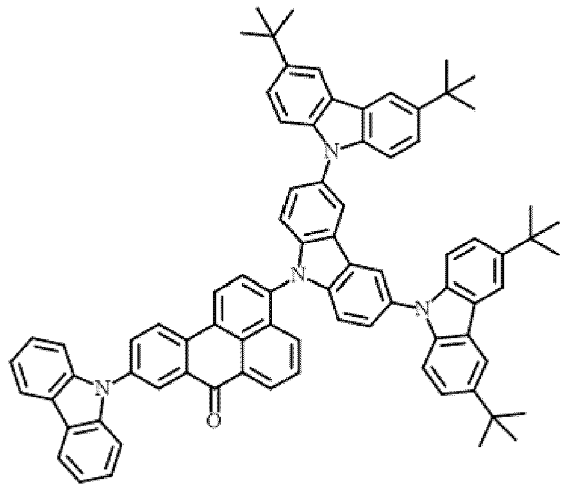

54

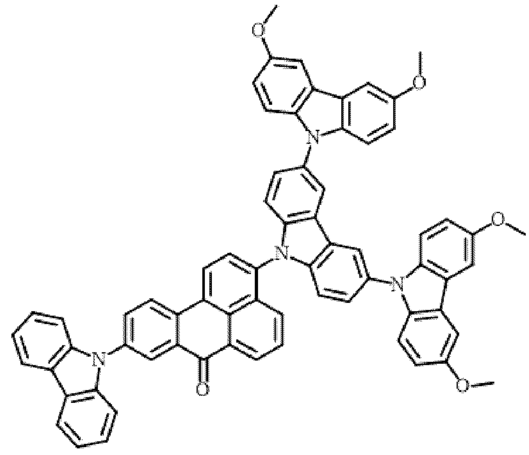

55

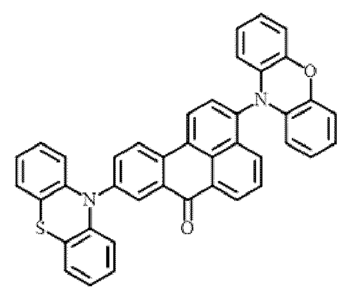

56

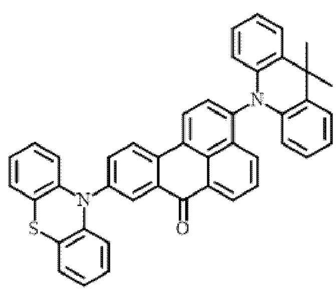

57

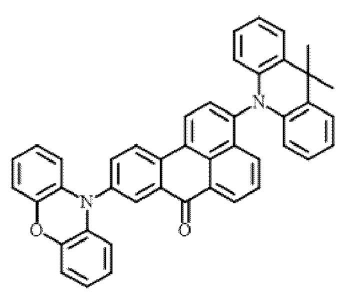

58

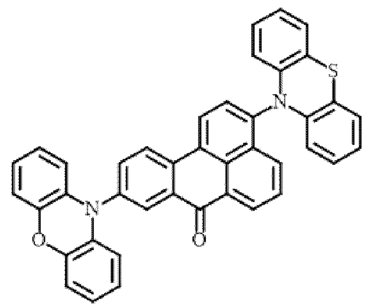

59

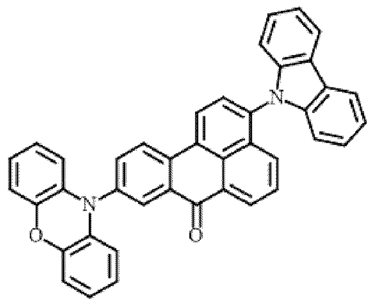

60

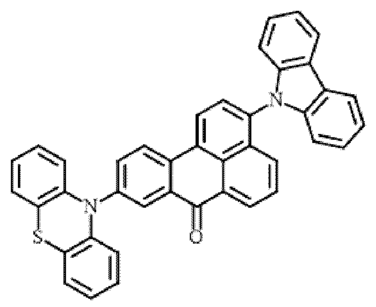

61

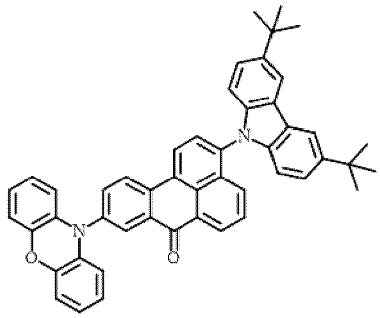

62

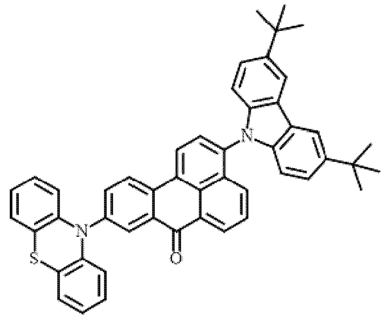

63

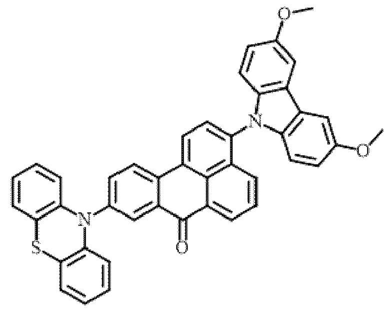

64

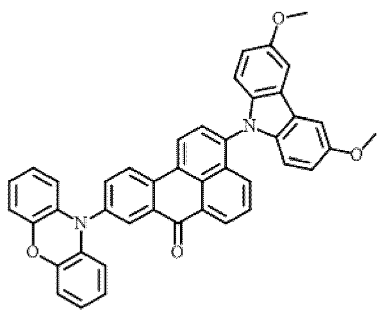

65

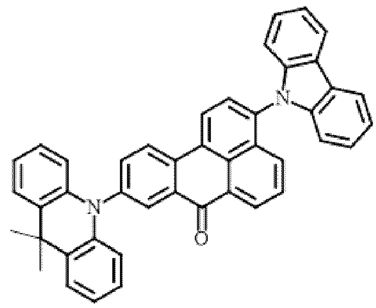

66

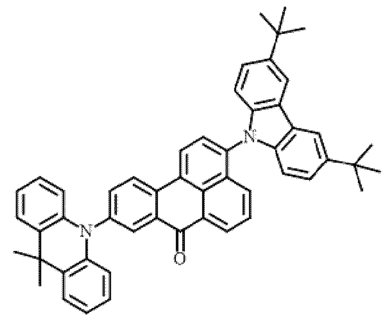

67

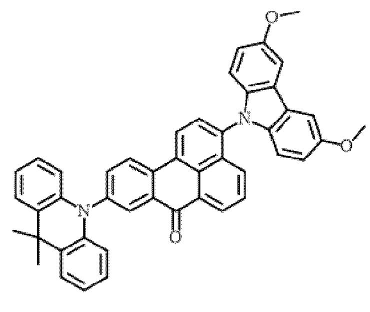

68

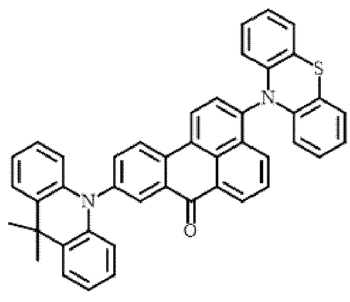

69

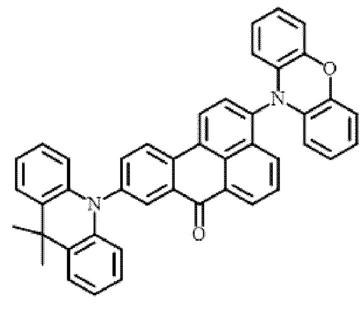

70

In various embodiments, the following definitions are applicable to the substituents of the compound of the general formula **(I):**

The substituents $R_1$, $R_2$, each independently denote a nitrogen-containing heteroaryl radical bonded via a nitrogen atom, or a radical of the formula - $N(Ar)_2$, N(HetAr)(Ar), $N(HetAr)_2$ , where each Ar is independently an aryl radical and each HetAr is independently a heteroaryl radical.

The substituents $R_1$, $R_2$, each independently denote a substituted or unsubstituted quinoline, indole, benzimidazole, phenazine, phenoxazine, phenothiazine, dibenzazepine, carbazole, 1,2,3,4-tetrahydrocarbazole or 9H - acridine radical, A|X such as a 2-phenylindole, 2-phenylbenzimidazole, 1,4-dihydro-2-phenylquinoline, 3-phenyl-1,4-benzoxazine, 3-phenyl-1,4-benzothiazine, phenoxazine, phenothiazine, 2,3-indolocarbazole, 2,3-(1-methylindolo)carbazole, or 9,9-dimethylacridine radical, each of which is bonded to the aromatic system of the formula **(I)** via the nitrogen atom in the main carbon ring.

According to thermal properties and solubility of the invented benzanthrone-based compounds of general formula (I), optoelectronic devices may be fabricated by wet-processable or vacuum-processable methods or their combination.

In various embodiments of the benzanthrone-based compounds of general formula (I), invented compounds may be appropriate for use in OLEDs as electroactive materials such as emitters, hosts, charge transporting/ charge-injecting/ charge blocking/ exciton blocking OLED layers, etc. Selection of invented compounds of general formula (I) for fabrication of OLEDs and their roles in OLED structures should be provided according to combination of their characteristics such as thermal properties, emission colour and colour purity, TADF, PLQY, HOMO/LUMO energy levels, charge transport properties, etc. To establish good charge injection and transport in OLEDs, appropriate device structures should be designed for the selected materials. In some cases, doping of selected benzanthrone-based compounds may be provided by additives which can improve conductivity and/or stability of functional layers. Multi-layered OLED structure may be needed with either optically transparent substrate and electrode (such as indium-tin-oxide (ITO) but not limited), with hole-injecting layer(s) (such as PEDOT:PSS, hexaazatriphenylenehexacabonitrile (HAT-CN), or molybdenum trioxide ($MoO_3$) but not limited), with doped and/or non-doped hole-transporting layer(s) (such as N,N'-di(1-naphthyl)-N,N'-diphenyl-(1,1'-biphenyl)-4,4'-diamine (NPB), tris(4-carbazoyl-9-ylphenyl)amine (TCTA), 3-Bis(9-carbazolyl)benzene (mCP) but not limited), with electron/exciton blocking layer(s), with doped and/or non-doped light-emitting layer(s) using hosts (such as mCP, 3,6-Di(9-carbazolyl)-9-(2-ethylhexyl)carbazole (TCz1) but not limited) or/and emitters (such as 2,3,5,6-tetrakis(3,6-diphenyl-9H-carbazol-9-yl)-1,4-benzenedicarbonitrile (4CzTPN-Ph), bis(1-phenyl-isoquinoline-C2,N)(acetylacetonato)iridium(III) (Ir(piq)2(acac)) but not limited), with hole/exciton blocking layer(s) (such as diphenyl-4-triphenylsilyl-phenylphosphineoxide (TSPO1) but not limited), with electron transporting layers (such as 2,2',2"-(1,3,5-benzinetriyl)-tris(1-phenyl-1-H-benzimidazole) (TPBi) but not limited), with electron-injecting layer(s) (such as fluorolithium (LiF) but not limited) or second electrode. According to embodiments of the benzanthrone-based compounds of general formula (I), invented materials may play practically each mentioned above role of multi-layered OLEDs preferably roles of infrared emitters or hosts for infrared emitters. The thickness of all layers should be carefully controlled by optimizing the fabrication processes.

Besides, according to various embodiments of the benzanthrone-based compounds of general formula (I), the invented materials may be used for the fabrication of light-emitting diodes based on perovskite materials. The structure of such devices may consist ITO anode, PEDOT:PSS as hole-injection layer, a layer of perovskite-based light-emitting material, an electron transporting layer based on the invented compound(s) and cathode.

In another embodiment of the benzanthrone-based compounds of general formula (I), the invented materials may be used as absorber and/or charge transporting material in organic and/or hybrid photo detectors and solar cells. Perovskite solar cells may be fabricated using the invented compounds as organic hole-transporting materials. Characteristics of these perovskite solar cells may be comparable with spiro-OMeTA-based perovskite solar cells with active perovskite layers fabricated from perovskite precursor solutions based on FAI, $PbI_2$, CsI and $PbBr_2$ powders dissolved in anhydrous DMF:DMSO solvent mixture.

In a further embodiment of the benzanthrone-based compounds of general formula (I), invented compounds may be used as functional materials to enhance light-emitting efficiency, charge transport properties, and values of energy in the form of emitters, hosts, charge/exciton-blocking or charge transport materials for vertically configured organic light-emitting transistors (VOLETs). The simplest structure of such a VOLET includes 1st electrode/organic layer(dielectric)/2nd porous electrode/organic layer/3rd electrode deposited one by one.

In yet another embodiment, the benzanthrone-based compounds of general formula (I) with long-lived infrared emission may be used as active materials in optical chemo-sensors (oxygen sensors) because excited triplet energy states can be quenched by external stimulus. Long-lived luminescence properties (emission colour, intensity, lifetime etc.) of benzanthrone-based compounds of general formula (I) may be media dependent being potential for optical sensors.

In various embodiments of the benzanthrone-based compounds of general formula (I), not only measurements of analytes (pH, metal ions, ammonia, carboxylic, etc.) but also visualization/imaging of their distribution may be possible with the help of contactless optical sensors. Sensitivity of environment-responsive materials based on the benzanthrone derivatives may be roughly proportional to emission decay time of such materials.

Solution-based coating techniques are predictably suited for high-speed coating or printing of optoelectronic devices with very low process costs. Anchoring groups (alkyl, metyl, metoxy, or *tert*-butyl substituents of used donors) can be used with the purpose to increase solubility and film-forming properties of benzanthrone-based compounds of general formula (I) making them suitable for solution-processable optoelectronic devices.

## EXAMPLES

Information on examples of real embodiments is provided below, describing the modes of synthesis compounds (1-6) of present invention and their properties. This information is provided for the illustrative purpose and is not limiting

the scope of the present invention.

**Example 1.**

*3-(3,6-di-tert-butyl-9H-carbazol-9-yl)-7H-benzo[de]anthracen-7-one (see scheme 1, compound 1)*

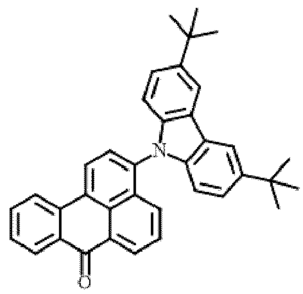

The mixture of 3-bromo-7*H*-benzo[*de*]anthracen-7-one (0.3 g, 0.96 mmol), 3,6-di-*tert*-butyl-9*H*-carbazole (0.297 g, 1.1 mmol), tris(dibenzylideneacetone)dipalladium(0) (0.026 g, 0.03 mmol), 2-dicyclohexylphosphino-2',4',6'-triisopropylbiphenyl (0.014 g, 0.03 mmol) and sodium *tert*-butoxide (0.233 g, 2.5 mmol) in toluene (100 ml) was heated to 110 °C under an argon atmosphere during 24 hours. After the reaction mixture was cooling to room temperature and filtered through Celite and the solvent was removed under reduced pressure. The product was purified by column chromatography on silica gel using the eluent mixture of hexane and toluene with the volume ratio of 1:1 and recrystallized from methanol. Obtained yellow crystals were dried under vacuum at 50 °C and were isolated in 52 % yield (0.26 g).
**$^{1}$H NMR** (400 MHz, $CDCl_3$) δ 8.85 (d, J = 7.1 Hz, 1H), 8.62 (dd, J = 20.1, 7.7 Hz, 2H), 8.44 (d, J = 8.1 Hz, 1H), 8.25 (d, J = 1.6 Hz, 2H), 7.96 - 7.80 (m, 3H), 7.66 (m, 2H), 7.43 (dt, J = 8.7, 4.4 Hz, 2H), 7.01 (d, J = 8.6 Hz, 2H), 1.50 (d, J = 9.1 Hz, 18H).
**$^{13}$C NMR** (101 MHz, $CDCl_3$) δ 183.80, 143.24, 140.79, 137.00, 135.75, 133.69, 131.14, 131.05, 130.54, 130.48, 129.29, 129.13, 128.76, 128.34, 127.32, 127.28, 126.97, 124.32, 123.88, 123.53, 123.32, 116.40, 109.53, 32.04.
**Elemental analysis:** Calculated, %: C 87.54; H 6.55; N 2.76; O 3.15. $C_{37}H_{33}NO$. Found, %: C 88.01; H 6.30; N 2.66; O 3.03.
**ESI-MS** *(m/z):* calculated for $C_{37}H_{33}NO$ 507.66 $[M + H]^+$; found, 507.39.

**Example 2.**

*3-(10H-phenothiazin-10-yl)-7H-benzo[de]anthracen-7-one (see scheme 1, compound **2**)*

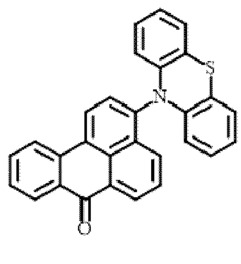

The mixture of 3-bromo-7H-benzo[de]anthracen-7-one (0.3 g, 0.96 mmol), 10*H*-phenothiazine (0.297 g, 1.1 mmol), tris(dibenzylideneacetone)dipalladium(0) (0.026 g, 0.03 mmol), 2-dicyclohexylphosphino-2',4',6'-triisopropylbiphenyl (0.014 g, 0.03 mmol) and sodium *tert*-butoxide (0.233 g, 2.5 mmol) in toluene (100 ml) was heated to 110 °C under an argon atmosphere during 24 hours. After the reaction mixture was cooling to room temperature and filtered through Celite and the solvent was removed under reduced pressure. The product was purified by column chromatography on silica gel using the eluent mixture of hexane and toluene with the volume ratio of 1:1 and recrystallized from methanol. Obtained red crystals were dried under vacuum at 50 °C and were isolated in 43% yield (0.18 g).
**$^{1}$H NMR** (400 MHz, $CDCl_3$) δ 8.83 (dt, *J* = 6.8, 3.4 Hz, 1H), 8.70 (d, *J* = 7.9 Hz, 1H), 8.57 (dd, *J* = 5.6, 3.9 Hz, 2H), 8.44

(d, $J$ = 8.0 Hz, 1H), 7.90 (d, $J$ = 7.8 Hz, 1H), 7.87 - 7.76 (m, 2H), 7.66 (m, 1H), 7.09 (dd, $J$ = 7.5, 1.6 Hz, 2H), 6.80 (m, 4H), 6.13 (dd, $J$ = 8.2, 1.0 Hz, 2H).
**$^{13}$C NMR** (101 MHz, $CDCl_3$) δ 183.64, 143.80, 139.37, 135.53, 133.71, 131.26, 131.09, 130.88, 130.65, 130.49, 129.99, 129.43, 128.95, 128.36, 127.93, 127.88, 127.05, 126.80, 124.71, 123.38, 122.87, 120.02, 115.87.
**Elemental analysis:** Calculated, %: C 81.47; H 4.01; N 3.28; O 3.74; S 7.50. $C_{29}H_{17}NOS$. Found, %: C 82.16; H 3.86; N 3.16; O 3.60; S 7.22.
**ESI-MS** *(m/z):* calculated for $C_{29}H_{17}NOS$ 427.52 $[M + H]^+$; found, 427.19.

**Example 3.**

*3-(10H-phenoxazin-10-yl)-7H-benzo[de]anthracen-7-one (see scheme 1, compound **3**)*

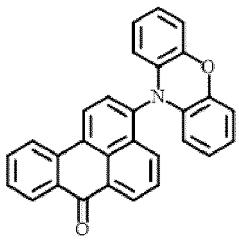

The mixture of 3-bromo-7*H*-benzo[*de*]anthracen-7-one (0.3 g, 0.96 mmol), 10H-phenoxazine (0.195 g, 1.1 mmol), tris(dibenzylideneacetone)dipalladium(0) (0.026 g, 0.03 mmol), 2-dicyclohexylphosphino-2',4',6'-triisopropylbiphenyl (0.014 g, 0.03 mmol) and sodium *tert*-butoxide (0.233 g, 2.5 mmol) in toluene (100 ml) was heated to 110 °C under an argon atmosphere during 24 hours. After the reaction mixture was cooling to room temperature and filtered through Celite and the solvent was removed under reduced pressure. The product was purified by column chromatography on silica gel using the eluent mixture of hexane and toluene with the volume ratio of 1:1 and recrystallized from methanol. Obtained red crystals were dried under vacuum at 50 °C and were isolated in 60 % yield (0.24 g).
**$^1$H NMR** (400 MHz, $CDCl_3$) δ 8.84 (dd, $J$ = 7.3, 1.0 Hz, 1H), 8.68 (d, $J$ = 7.9 Hz, 1H), 8.61 - 8.49 (m, 2H), 8.42 (d, $J$ = 8.1 Hz, 1H), 7.82 (m, 3H), 7.65 (t, $J$ = 7.5 Hz, 1H), 6.80 (dd, $J$ = 7.9, 1.3 Hz, 2H), 6.70 (td, $J$ = 7.7, 1.3 Hz, 2H), 6.55 (td, $J$ = 7.8, 1.3 Hz, 2H).
**$^{13}$C NMR** (101 MHz, $CDCl_3$) δ 183.57, 143.89, 137.56, 135.49, 134.23, 133.71, 131.25, 131.09, 130.65, 130.48, 130.04, 129.78, 129.55, 128.97, 128.37, 128.00, 127.93, 125.19, 123.50, 123.38, 121.81, 115.70, 113.52.
**Elemental analysis:** Calculated, %: C 84.65; H 4.16; N 3.40; O 7.78. $C_{29}H_{17}NO_2$. Found, %: C 85.25; H 4.00; N 3.27; O 7.48.
**ESI-MS** *(m/z):* calculated for $C_{29}H_{17}NO_2$ 411.45 $[M + H]^+$; found, 411.49.

**Example 4.**

*3,9-di(9H-carbazol-9-yl)-7H-benzo[de]anthracen-7-one (see scheme 2, compound **4**)*

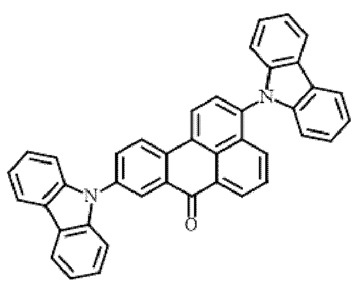

The mixture of 3,6-dibromo-7 H -benzo(de)anthracen-7-one (0.2 g, 0.52 mmol), 9H-carbazole (0.215 g, 1.29 mmol), tris(dibenzylideneacetone)dipalladium(0) (0.026 g, 0.03 mmol), 2-dicyclohexylphosphino-2',4',6'-triisopropylbiphenyl (0.014 g, 0.03 mmol) and sodium *tert*-butoxide (0.248 g, 2,57 mmol) in toluene (100 ml) was heated to 110 °C

under an argon atmosphere during 24 hours. After the reaction mixture was cooling to room temperature and filtered through Celite and the solvent was removed under reduced pressure. The product was purified by column chromatography on silica gel using the eluent mixture of hexane and toluene with the volume ratio of 1:1 and recrystallized from methanol. Obtained yellow crystals were dried under vacuum at 50 °C and were isolated in 40 %yield (0.12 g).

**$^1$H NMR** (400 MHz, $CDCl_3$) δ 8.90 (dd, *J* = 7.2, 1.1 Hz, 1H), 8.84 (d, *J* = 2.4 Hz, 1H), 8.75 (d, *J* = 8.0 Hz, 1H), 8.69 (d, *J* = 8.7 Hz, 1H), 8.28 (d, *J* = 7.0 Hz, 2H), 8.22 (d, *J* = 7.7 Hz, 2H), 8.08 (dd, *J* = 8.5, 2.4 Hz, 1H), 7.94 (d, *J* = 7.8 Hz, 1H), 7.88 (dd, *J* = 8.4, 1.0 Hz, 1H), 7.75 - 7.68 (m, 1H), 7.62 (d, *J* = 8.2 Hz, 2H), 7.51 (td, *J* = 8.3, 4.3 Hz, 2H), 7.47 - 7.30 (m, 6H), 7.13 (d, *J* = 7.5 Hz, 2H).

**$^{13}$C NMR** (101 MHz, $CDCl_3$) $^{13}$C NMR (101 MHz, $CDCl_3$) δ 183.08, 142.30, 140.46, 138.56, 138.46, 131.72, 131.00, 130.58, 129.21, 129.11, 127.70, 127.45, 126.30, 126.27, 125.88, 125.36, 124.64, 123.82, 123.57, 120.56, 120.51, 120.41, 110.11, 109.83.

**Elemental analysis:** Calculated, %: C 87.83; H 4.31; N 5.00; O 2.85. $C_{41}H_{24}N_2O$. Found, %: C 88.31; H 4.14; N 4.81; O 2.74.

**ESI-MS** *(m/z):* calculated for $C_{41}H_{24}N_2O$ 560.64 $[M + H]^+$; found, 560.66.

**Example 5.**

*3,9-di(10H-phenothiazin-10-yl)-7H-benzo[de]anthracen-7-one (see scheme 2, compound 5)*

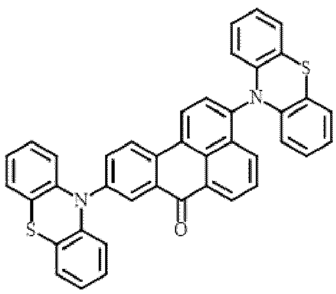

The mixture of 3,6-dibromo-7*H*-benzo(*de*)anthracen-7-one (0.2 g, 0.52 mmol), 10H-phenothiazine (0.256 g, 1.28 mmol), tris(dibenzylideneacetone)dipalladium(0) (0.026 g, 0.03 mmol), 2-dicyclohexylphosphino-2',4',6'-triisopropylbiphenyl (0.014 g, 0.03 mmol) and sodium *tert*-butoxide (0.248 g, 2,57 mmol) in toluene (100 ml) was heated to 110 °C under an argon atmosphere during 24 hours. After the reaction mixture was cooling to room temperature and filtered through Celite and the solvent was removed under reduced pressure. The product was purified by column chromatography on silica gel using the eluent mixture of hexane and toluene with the volume ratio of 1:1 and recrystallized from methanol. Obtained yellow crystals were dried under vacuum at 50 °C and were isolated in 38 % yield (0.12 g).

**$^1$H NMR** (400 MHz, $CDCl_3$) δ 8.74 (d, *J* = 7.0 Hz, 1H), 8.59 (d, *J* = 7.9 Hz, 1H), 8.50 (d, *J* = 8.3 Hz, 1H), 8.45 - 8.37 (m, 1H), 7.82 (d, *J* = 7.8 Hz, 1H), 7.74 - 7.61 (m, 2H), 7.18 - 7.08 (m, 3H), 7.05 - 6.84 (m, 6H), 6.81 - 6.61 (m, 6H), 6.04 (d, *J* = 8.2 Hz, 2H).

**$^{13}$C NMR** (101 MHz, $CDCl_3$) δ 183.09, 143.71, 133.19, 132.77, 131.15, 130.98, 130.97, 130.81, 130.62, 129.48, 129.07, 128.16, 127.06, 125.82, 125.39, 125.10, 124.64, 124.06, 123.89, 122.91, 120.28, 119.64, 115.86, 112.32.

**Elemental analysis:** Calculated, %: C 78.82; H 3.87; N 4.48; O 2.56; S 10.26. $C_{41}H_{24}N_2OS_2$. Found, %: C 79.64; H 3.72; N 4.31; O 2.46; S 9.87.

**ESI-MS** *(m/z):* calculated for $C_{41}H_{24}N_2OS_2$ 624.77 $[M + H]^+$; found, 624.78.

**Example 6.**

*3,9-di(10H-phenoxazin-10-yl)-7H-benzo[de]anthracen-7-one (see scheme 2, compound* ***6)***

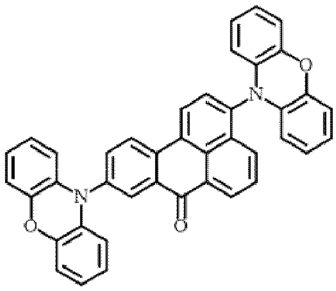

The mixture of 3,6-dibromo-7*H*-benzo(*de*)anthracen-7-one (0.2 g, 0.52 mmol), 10H-phenoxazine (0.236 g, 1.28 mmol), tris(dibenzylideneacetone)dipalladium(0) (0.026 g, 0.03 mmol), 2-dicyclohexylphosphino-2',4',6'-triisopropylbiphenyl (0.014 g, 0.03 mmol) and sodium *tert*-butoxide (0.248 g, 2,57 mmol) in toluene (100 ml) was heated to 110 °C under an argon atmosphere during 24 hours. After the reaction mixture was cooling to room temperature and filtered through Celite and the solvent was removed under reduced pressure. The product was purified by column chromatography on silica gel using the eluent mixture of hexane and toluene with the volume ratio of 1:1 and recrystallized from methanol. Obtained red crystals were dried under vacuum at 50 °C and were isolated in 55 % yield (0.17 g).

**$^1$H NMR** (400 MHz, $CDCl_3$) δ 8.88 (d, *J* = 6.3 Hz, 1H), 8.73 (d, *J* = 8.0 Hz, 1H), 8.65 (d, *J* = 8.5 Hz, 1H), 8.58 (dd, *J* = 7.6, 5.3 Hz, 2H), 7.90 - 7.80 (m, 3H), 6.87 - 6.68 (m, 8H), 6.64 (t, *J* = 7.6 Hz, 2H), 6.60 - 6.53 (m, 2H), 6.07 (d, *J* = 7.8 Hz, 2H), 5.81 (dd, *J* = 8.0, 1.1 Hz, 2H).

**$^{13}$C NMR** (101 MHz, $CDCl_3$) δ 182.41, 143.90, 138.27, 136.37, 135.39, 134.17, 133.60, 131.33, 131.12, 130.88, 130.17, 129.94, 129.30, 128.18, 127.26, 126.64, 125.82, 123.51, 123.33, 121.94, 121.85, 115.78, 113.49, 113.42.

**Elemental analysis:** Calculated, %: C 83.09; H 4.08; N 4.73; O 8.10. $C_{41}H_{24}N_2O_3$. Found, %: C 83.74; H 3.92; N 4.55; O 7.79.

**ESI-MS** *(m/z):* calculated for $C_{41}H_{24}N_2O_3$ 592.64 $[M + H]^+$; found, 592.49.

**Example 7.**

*Photophysical properties of compounds 1-6.*

UV-vis spectra of samples (dilute solutions using differently polar solvents and non-doped films) were recorded on a PerkinElmer Lambda 35 and/or Avantes AvaSpec-2048XL spectrometers. Photoluminescence (PL) spectra, PL quantum yields (PLQY), and PL decay curves of either solutions or solid films (non-doped and doped ones using ZEONEX and/or mCP as hosts) were recorded by a FLS980 fluorescence spectrometer. Edinburgh Instruments FLS980 spectrometer was also exploited for recording PL decay curves using PicoQuant LDH-DC- 375 laser (wavelength 374 nm) as the excitation source. An integrated sphere (inner diameter of 120 mm) spherical cavity calibrated with two analytical standards: quinine sulphate in 0.1 M $H_2SO_4$ and rhodamine 6G in ethanol was used for the measurements of fluorescence quantum yields. The main results of those photophysical characterizations of compounds 1-6 were collected in Table 1 and visualized in Figs. 1-3.

Mono- and bi-carbazole substituted benzanthrone derivatives (compounds 1 and 4) emitted green light in their dilute ($0.5\text{-}5\times10^{-5}$ mol $L^{-1}$) toluene solutions under UV excitation ($\lambda_{ext}$=350 nm). PL spectra of those toluene solutions 1 and 4 were peaked at 530 and 527 nm and were corresponded to green emission with PLQYs of 53 and 84 %, respectively (Fig. 1, Table 1). PL spectra of non-doped and mCP-doped films of compounds 1 and 4 were red-shifted displaying solvatochromic effect since toluene, mCP and non-doped films are definitely characterized by different dielectric constants (Table 1). Such solvatochromic effect is usual for donor-acceptor type molecules and it is a mark of intramolecular charge transfer (ICT) nature of emission of such materials. Apparently, emission of compounds 1 and 4 were resulted from recombination of ICT excited energy states. Since PL decays of compounds 1 and 4 were recorded in nanosecond range, their emission is related to simple fluorescence (resulted from recombination of singlet ICT energy states) (Fig. 2).

Donor-acceptor type compound 1 consisting of benzanthrone and carbazole units showed additionally mechanoresponsive luminescence. The emission of compound 1 changed under applying external stimuli. When the mechanical force was applied to initial powder of 1, the fluorescence colour changed from green (554 nm) to orange (606 nm) (Fig. 3). Melting process of the initial powder resulted in yellow emission with fluorescence peak of the melted sample at 588 nm. Alteration of the emission colour could be due to the different molecular pickings and, thus, different molecular interactions of initial, ground, and melted states. Due to the mechanoluminescence properties of compound 1, this compound can be used for wide applications prospects such as memory devices, sensors, and data storage.

Table 1. Photophysical parameters of compounds 1-6.

| Compound | Formula | $\lambda^{tol}$PL, nm | $\lambda^{film}$PL, nm | $\Phi^{tol}$PL, % | $\Phi^{film}$PL, % | $\lambda^{film}$PL, in mCP host with 10tw.% of compound, nm | $\Phi^{film}$PL, in mCP host with 10tw.% of compound, % |
|---|---|---|---|---|---|---|---|
| **1** | 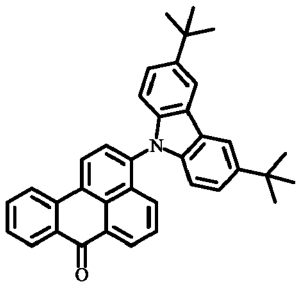 | 530 | 590 | 53 | 22 | 540 | 16 |
| **2** | 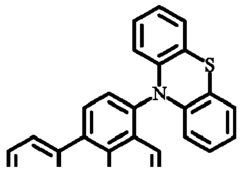 | 710 | 712 | 1 | 1 | 660 | 2 |
| **3** | | 680 | 694 | 1 | 1 | 648 | 4 |
| **4** | 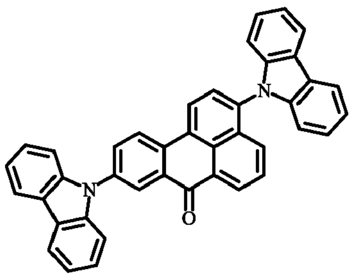 | 527 | 584 | 84 | 25 | 556 | 48 |

(continued)

| Compound | Formula | $\lambda^{tol}$PL, nm | $\lambda^{film}$PL, nm | $\Phi^{tol}$PL, % | $\Phi^{film}$PL, % | $\lambda^{film}$PL, in mCP host with 10tw.% of compound, nm | $\Phi^{film}$PL, in mCP host with 10tw.% of compound, % |
|---|---|---|---|---|---|---|---|
| **5** | 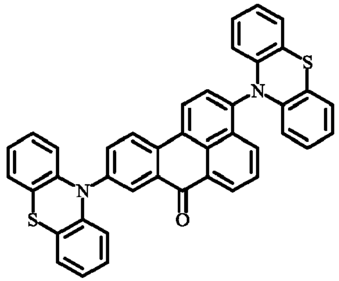 | 746 | 720 | 1 | 1 | 635 | 9 |
| **6** | 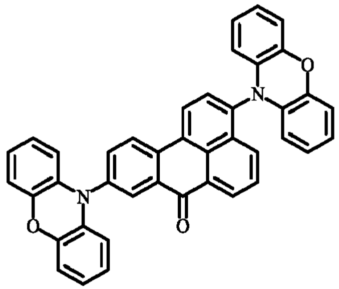 | 724 | 696 | 1 | 1 | 664 | 1 |

In case of compounds 2, 3, 5 and 6, emission is also mainly resulted of recombination of ICT energy states formed between benzanthrone and donor used (Fig. 1). Their PL spectra were recorded in red-near-infrared region. Donating abilities of donors used for the substitutions of the invented benzanthrone derivatives determine their emission spectra. Since donating abilities of phenothiazine and phenoxazinyl than that of carbazole, PL spectra of compounds 2, 3, 5 and 6 are much red-shifted than PL spectra of compounds 1 and 4. In contrast to that of compounds 1 and 4, compounds 2, 3, 5 and 6 were characterised by long-lived emission with lifetimes being in range from microseconds up to milliseconds (Fig. 2). Those long-lived emissions can be characterized by thermally activated delayed fluorescence (TADF) when ICT singlets are close to local excited (LE) triplets of benzanthrone moiety. When singlet-triplet energy splitting of invented derivatives of benzanthrone is small enough, they can exhibit TADF in near infrared region (Figs. 1, 2).

It is widely accepted that TADF OLED emitters allow to harvest both singlet and triplet energy injected to OLED structure under electrical excitation. When the donating substitutions will be successfully selected, light-emitting compounds of the general formula (I) based on benzanthrone moiety can emit in near infrared TADF being potential for optoelectronic device applications such as organic light-emitting diodes, light- emitting field-effect transistors, light-emitting vertical transistors, optical sensors (Fig. 1). Such achievement relates to strong electron-accepting abilities of benzanthrone moiety.

**Example 8.**

*Characterizations of thermal properties of compounds 1-6.*

Differential scanning calorimetry (DSC) measurements were recorded using PerkinElmer DSC 8500 equipment at heating and cooling rates of 10 °C/min in a nitrogen atmosphere. Thermogravimetric experiments (TGA) were done using PerkinElmer TGA 4000 apparatus at a heating rate of 20 °C/min in a nitrogen atmosphere. The main results of those thermal characterizations of compounds 1-6 were collected in the Table 2.

The invented compounds 1-6 were characterized by relatively high thermal stability since their temperature of 5% weight loss ($T_{d-5\%}$,) was exceeding 300°C and 400°C for donor-acceptor and donor-acceptor-donor compounds, respectively (Table 2). In addition, glass-transition temperatures ($T_g$) higher than 100 °C were obtained for the compounds 1-6 during the second heating scan displaying that they form molecular glasses. Highest $T_g$ value was obtained for donor-acceptor-donor molecule 5 substituted by strongly-donating phenothiazine units. Crystallization peak was recorded for compounds 1, 2, 4, 6 during the first cooling scan.

Table 2. Thermal characteristics, ionization potential and hole/electron mobilities of compounds 1-6.

| Compounds | Formula | $T_m$, ºC | $T_{cr}$, ºC | $T_g$**, ºC | $T_{des\text{-}5\%}$, ºC | $IP^{EP}$, eV | $\mu^{holes}$, $cm^2/V \cdot s$ at $3.6 \cdot 10^5$ V/cm | $\mu^{electrons}$, $cm^2/V \cdot s$ at $3.6 \cdot 10^5$ V/cm |
|---|---|---|---|---|---|---|---|---|
| **1** | 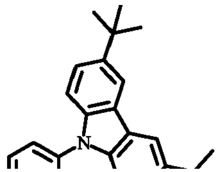 | 265*, 296** | 200** | 122 | 345 | 5.85 | $1.8 \times 10^{-4}$ | $6 \times 10^{-5}$ |
| **2** | | 286*, ** | 172** | 111 | 364 | 5.68 | $9.8 \times 10^{-6}$ | $1.5 \times 10^{-4}$ |
| **3** | 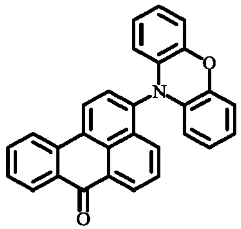 | - | - | 114 | 336 | - | - | - |
| **4** | 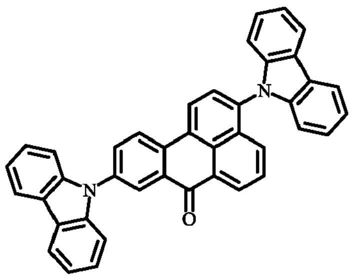 | 372*, ** | 220** | 168 | 425 | 5.93 | - | - |
| **5** | 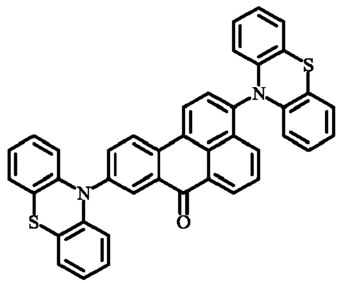 | - | - | 174 | 420 | - | - | - |

(continued)

| Compounds | Formula | $T_m$, ºC | $T_{cr}$, ºC | $T_g^{**}$, ºC | $T_{des-5\%}$, ºC | $IP^{EP}$, eV | $\mu^{holes}$, $cm^2/V \cdot s$ at $3.6 \cdot 10^5$ V/cm | $\mu^{electrons}$, $cm^2/V \cdot s$ at $3.6 \cdot 10^5$ V/cm |
|---|---|---|---|---|---|---|---|---|
| **6** | 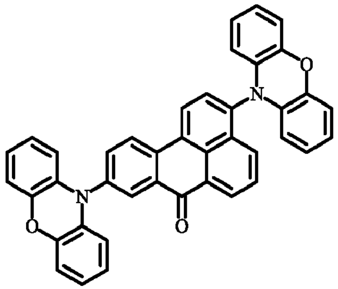 | $391^{*,**}$ | $213^{**}$ | 170 | 419 | 5.49 | $7.4 \times 10^{-8}$ | $1.1 \times 10^{-4}$ |

**Example 9.**

*Characterizations of energy levels of compounds 1-6.*

To estimate the ionization potentials ($IP^{PESA}$) of the compounds 1-6 in solid-state, photoelectron emission spectra of vacuum-deposited layers were recorded by electron photoemission spectroscopy in air (PESA) [E. Miyamoto, Y. Yamaguchi, M. Masaaki, Electrophotography, 1989, vol. 28, pp. 364]. The samples for photoelectron emission measurements were fabricated under vacuum of $1\text{-}4\times10^{-6}$ bar onto glass substrates with fluorine-doped tin oxide-based electrode. Those layers 1-6 were vacuum deposited with Kurt J. Lesker equipment integrated into glove box. Electron photoemission current was recorded under different excitation photon energies with step of 1 nm. To provide that excitation, monochromator (CM110 1/8m) and deuterium lamp (emitted by ASBN-D130-CM) were used. +300 V was applied to a counter electrode and electron photoemission current in a circuit under different excitation wavelengths and recorded using 6517B Keithley electrometer. The $IP^{PESA}$ values obtained by PESA measurements of compounds 1-6 were collected in the Table 2.

The $IP^{PESA}$ values of the invented compounds 1, 2, 4, 6 were found to be below 6.0 eV meaning that holes can be easily injected from electrodes using appropriate device structures. The $IP^{PESA}$ values of the invented compounds 3 and 5 were found not obtained by PESA experiments apparently due to limitation of this method due to the absorption of deep-UV light by oxygen presented in air.

**Example 10.**

*Charge-transporting measurements of compounds 1-6.*

To investigate charge-transporting properties of the layers of the compounds 1-6 containing benzanthrone, time of flight (TOF) method was exploited. In setup of this method, EKSPLA NL300 laser (excitation wavelength of 355 nm), 6517B electrometer (Keithley), and TDS 3032C oscilloscope (Tektronix) were used. To test ability to transport holes and electrons of compounds 1-6, TOF transients under positive and negative polarity of applied electric fields were recorded. When two different slopes (intercepts of which give the transit times ($t_{tr}$)) were obtained from corresponding TOF transients build in log-log scales, hole and/or electron transport was proved for the tested samples. Hole and electron mobilities were calculated according to the equation $\mu = d^2/(U \times t_{tr})$ taking transit times $t_{tr}$ from the photocurrent transients at applied voltage (U) and thicknesses of the layers (d) measured by the charge extraction by linearly increasing voltage (CELIV) technique assuming dielectric constant $\varepsilon = 3$ for the studied compounds. TOF samples were fabricated on prepatterned and precleaned ITO glass substrates with sheet resistance 15 $\Omega$/sq where ITO is optically-transparent indium tin oxide-based electrode. Tested films were vacuum deposited with Kurt J. Lesker equipment integrated into glove box.

Bipolar charge transport with relatively strong dispersity was observed for vacuum-deposited films of compounds 1, 2 and 6. Taking transit times at different applied voltages, hole and electron mobilities were calculated for those compounds and their dependences on electric field were in good agreement with Poole-Frenkel type mobility predicted by the relationship $\mu = \mu_0 e^{\alpha E^{1/2}}$. At electric field of $3.6\cdot10^5$ V/cm, relatively similar electron mobility values ($6\times10^{-5}$-$15\times10^{-5}$ $cm^2/V\cdot s$) were obtained for compounds 1, 2 and 6 apparently because the same electron accepting moiety was exploited in their molecular structures (Table 2). Slight differences of their electron mobilities may relate to molecular packing differences in their vacuum-deposited films. At the same electric field of $3.6\cdot10^5$ V/cm, large variety of hole mobility values ($7.4\times10^{-8}$-$1.8\times10^{-4}$ $cm^2/V\cdot s$) was obtained for compounds 1, 2 and 6 since different electron-donating unites were used in molecular structures of tested compounds (Table 2). By TOF measurements, the bipolar charge-transporting properties which are important for OLEDs were demonstrated for some members of the invented compounds.

Donor-acceptor organic compounds containing benzanthrone moiety(ies) disclosed by this invention can be easily obtained. Readily available materials employed for the one-step and efficient synthesis will have low environmental impact. The donor-substituted benzanthrone derivatives can be used in optoelectronic devices as functional materials exhibiting both hole and electron mobilities (as hosts of doped organic/hybrid light-emitting diodes; as the emitters of non-doped/doped organic/hybrid light-emitting diodes, as materials for active layers of organic/hybrid photodetectors, of organic/hybrid light-emitting/field-effect transistors, etc.). The donor-substituted benzanthrone derivatives can also be used as functional materials with triplet harvesting abilities in organic/hybrid electroluminescent devices because they demonstrate long-lived fluorescence related to triplet harvesting (Fig. 2). In addition, compounds can be used as active materials in optical sensors of oxygen; the working mechanism of which is based on quenching of long-lived triplet-related fluorescence. Due to the mechanochromic properties, they can also be used for imaging probes and as active material in memory devices. Compounds can be additionally used as deep-red/near-infrared emitters in many

applications where such emission is needed (e.g. bioimaging, electroluminescent devices for telecommunication systems, sensors).

## Claims

1. A bipolar organic light-emitting semiconductor containing benzanthrone moiety according to general formula (I):

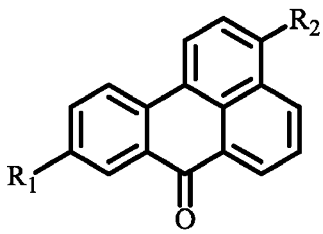

wherein $R_1$ and/ or $R_2$ is a mono- or polycyclic system comprising at least one pair of a conjugated double bond (-C=C-), the polycyclic system comprising fused aromatic rings or monocyclic aromatic rings bound together by covalent bond or heteroaromatic system with N, O, S, Se, Si B, heteroatoms;
said mono-polycyclic system being substituted by H, halogen, cyano, group, C1-C20 cyanoalkyl group, C1-C20 alkyl, C1-C20 alkoxy group, C1-C20 alkoxyalkyl, C1-C20 haloalkyl group, C1-C20 haloalkoxyalkyl, C4-C20 alkylaryl, C4-C20 alkoxyaryl C4-C20 alkenylarylalkyl, C4-C20 alkoxyarylalkenyl, C4-C20 bisalkoxyarylaalkenyl;
where said cyanoalkyl, alkyl, alkoxy, alkoxyalkyl, haloalkyl, haloalkoxyalkyl, C4-C20 alkylaryl, C4-C20 alkoxyaryl C4-C20 alkenylarylalkyl, C4-C20 alkoxyarylalkenyl, C4-C20 bisalkoxyarylaalkenyl groups may be linear, branched or cyclic;
where halogen is selected from Cl, F, Br, or I.

2. The bipolar organic light-emitting semiconductor according to claim 1, wherein the substituents $R_1$, $R_2$, each independently denote a nitrogen-containing heteroaryl radical bonded via a nitrogen atom, or a radical of the formula -$N(Ar)_2$, N(HetAr)(Ar), $N(HetAr)_{2;}$ wherein each Ar is independently an aryl group and each HetAr is independently a heteroaryl group.

3. The bipolar organic light-emitting semiconductor according to claim 1, wherein the substituents $R_1$, $R_2$, each independently denote a substituted or unsubstituted quinoline, indole, benzimidazole, phenazine, phenoxazine, phenothiazine, dibenzazepine, carbazole, 1,2,3,4-tetrahydrocarbazole or 9H-acridine moiety, each of which is bonded to the aromatic system of formula (I) via the nitrogen atom in the main carbon ring of the substituent.

4. The bipolar organic light-emitting semiconductor according to claim 3, wherein the substituent $R_1$, $R_2$, each independently denote 2-phenylindole, 2-phenylbenzimidazole, 1,4-dihydro-2-phenylquinoline, 3-phenyl-1,4-benzoxazine, 3-phenyl-1,4-benzothiazine, phenoxazine, phenothiazine, 2,3-indolocarbazole, 2,3-(1-methylindolo)carbazole, or 9,9-dimethylacridine moiety, each of which is bonded to the aromatic system of the formula (I) via the nitrogen atom in the substituents' main carbon ring.

5. The bipolar organic light-emitting semiconductor according to claims 1-4, which contains anchoring groups, alkyl, metyl, metoxy, or *tert*-butyl substituents of $R_1$ and/or $R_2$ groups.

6. The bipolar organic light-emitting semiconductor according any of the claims 1-5, wherein the bipolar organic light-emitting semiconductor containing benzanthrone represented by the general formula (I) is selected from the following compounds:

3-(3,6-di-tert-butyl-9H-carbazol-9-yl)-7H-benzo[de]anthracen-7-one,
3-(10H-phenothiazin-10-yl)-7H-benzo[de]anthracen-7-one,
3-(10H-phenoxazin-10-yl)-7H-benzo[de]anthracen-7-one,
3,9-di(9H-carbazol-9-yl)-7H-benzo[de]anthracen-7-one,
3,9-di(10H-phenothiazin-10-yl)-7H-benzo[de]anthracen-7-one,
3,9-di(10H-phenoxazin-10-yl)-7H-benzo[de]anthracen-7-one.

7. The use of the bipolar organic light-emitting semiconductor according to claims 1-5 as electroactive materials such as emitters, hosts, charge-transporting, charge-injecting, charge-blocking, or exciton-blocking materials in an organic light-emitting diode.

8. The use of bipolar organic light-emitting semiconductor according to claims 1-5 as material in light-emitting diodes based on perovskites; the LED consisting essentially of an indium-tin-oxide anode, a layer of PEDOT:PSS as hole-injection layer, and a layer of perovskite-based light-emitting material, an electron transport layer of the claimed compound(s) and a cathode.

9. The use of bipolar organic light-emitting semiconductor according to claims 1-5 as absorber and/or charge transporting material in organic and/or hybrid photo detectors and solar cells.

10. The use of bipolar organic light-emitting semiconductor according to claims 1-5 as functional materials of vertically configured organic light-emitting transistors (VOLETs).

11. The use of bipolar organic light-emitting semiconductors according to claims 1-5 in optical chemo-sensors.

12. The use of bipolar organic light-emitting semiconductor according to claims 1-5 as imaging probes and as active material in memory devices.

13. The use of bipolar organic light-emitting semiconductor according to claims 1-5 as active material in memory devices.

14. The use of bipolar organic light-emitting semiconductor according to claims 1-5 as deep-red and/or near-infrared emitters in bioimaging devices.

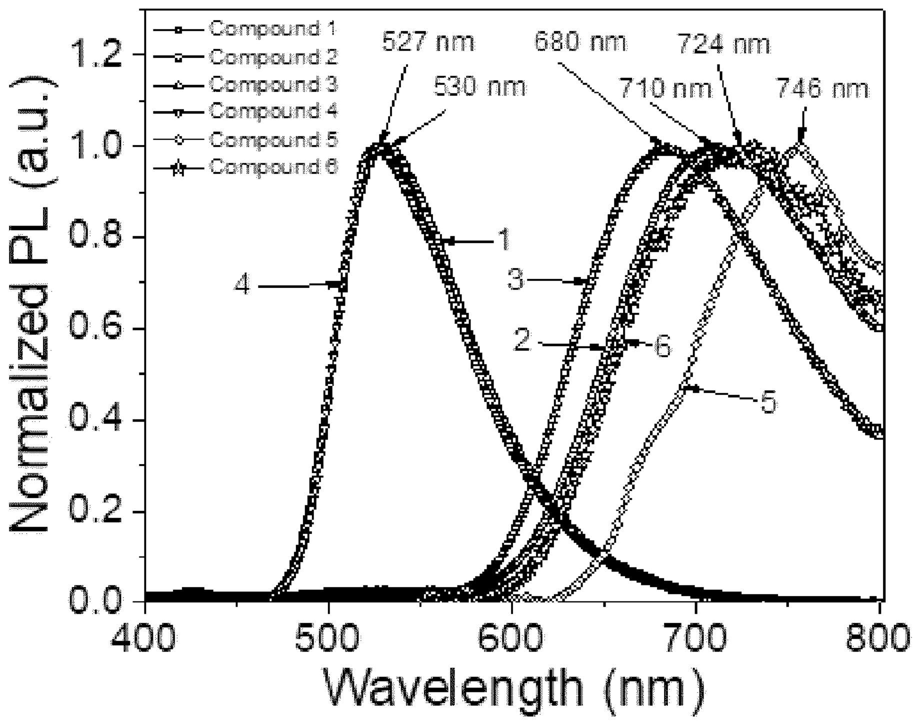
Compound 1
Compound 2
Compound 3
Compound 4
Compound 5
Compound 6
527 nm
530 nm
680 nm
710 nm
724 nm
746 nm
Normalized PL (a.u.)
Wavelength (nm)

Fig. 1

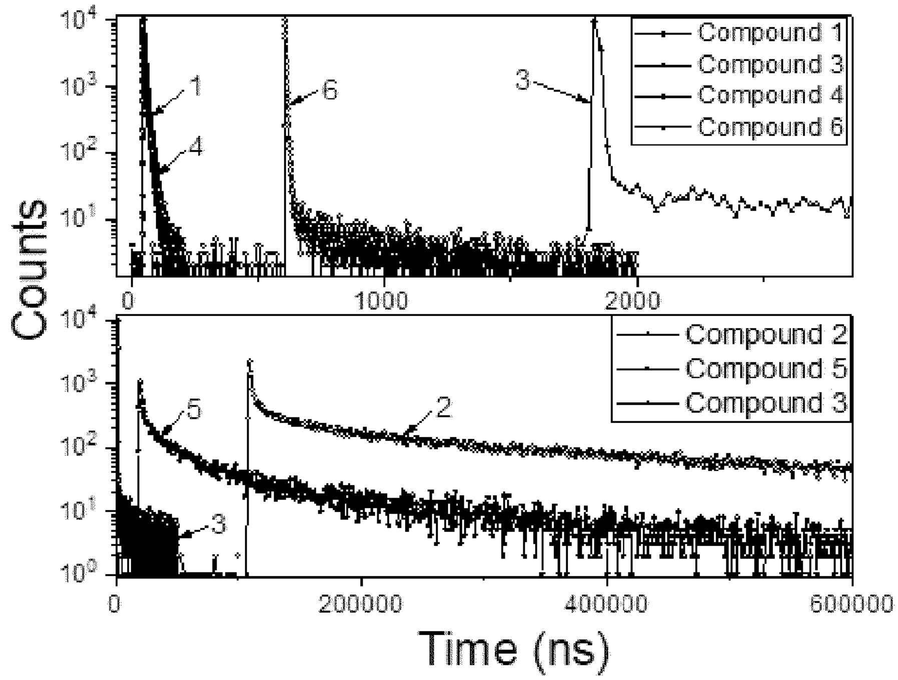
Compound 1
Compound 3
Compound 4
Compound 6
Compound 2
Compound 5
Compound 3
Counts
Time (ns)

Fig. 2

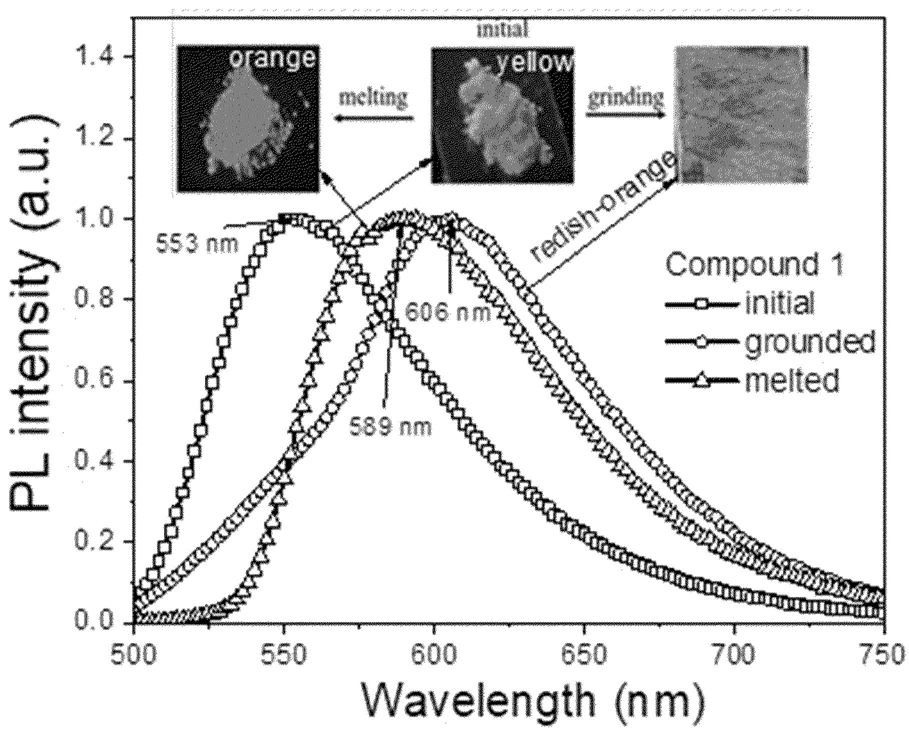
initial
orange
yellow
melting
grinding
redish-orange
553 nm
606 nm
589 nm
Compound 1
initial
grounded
melted
PL intensity (a.u.)
1.4
1.2
1.0
0.8
0.6
0.4
0.2
0.0
500
550
600
650
700
750
Wavelength (nm)

Fig. 3

Europäisches Patentamt
European Patent Office
Office européen des brevets

# EUROPEAN SEARCH REPORT

Application Number
EP 20 20 1128

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP H07 90257 A (NISSHIN SPINNING) 4 April 1995 (1995-04-04) * paragraph [0004] - paragraph [0031]; claims 1-4; figures 1-3; compound XIII * | 1-14 | INV. H01L51/00 C09B3/02 |
| X<br>A | US 1 749 519 A (WILLY TRAUTNER ET AL) 4 March 1930 (1930-03-04) * the whole document * | 1<br>2-14 | |
| A | WO 2016/126423 A2 (DU PONT [US]) 11 August 2016 (2016-08-11) * the whole document * | 1-14 | |

TECHNICAL FIELDS SEARCHED (IPC)
H01L
C09B

The present search report has been drawn up for all claims

1

| Place of search | Date of completion of the search | Examiner |
|---|---|---|
| The Hague | 19 March 2021 | Konrádsson, Ásgeir |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

# ANNEX TO THE EUROPEAN SEARCH REPORT ON EUROPEAN PATENT APPLICATION NO. EP 20 20 1128

This annex lists the patent family members relating to the patent documents cited in the above-mentioned European search report.
The members are as contained in the European Patent Office EDP file on
The European Patent Office is in no way liable for these particulars which are merely given for the purpose of information.

19-03-2021

| Patent document cited in search report | Publication date | Patent family member(s) | Publication date |
|---|---|---|---|
| JP H0790257 A | 04-04-1995 | NONE | |
| US 1749519 A | 04-03-1930 | NONE | |
| WO 2016126423 A2 | 11-08-2016 | CN 107250087 A | 13-10-2017 |
| | | KR 20170109586 A | 29-09-2017 |
| | | US 2018062082 A1 | 01-03-2018 |
| | | WO 2016126423 A2 | 11-08-2016 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 20180016493 A
- US 20190378977 A
- WO 2015121241 A
- WO 2016108046 A


### Non-patent literature cited in the description


- *Nat. Photon.,* 2014, vol. 8, 326-332
- *ACS Appl. Mater. Interfaces,* 2016, vol. 8, 23190-23196
- *Nano Lett.,* 2015, vol. 15, 6332-6338
- *Chem. Rev.,* 2015, vol. 115, 11718-11940
- *J. Phys. Chem. C,* 2015, vol. 119, 26283-26289
- *Angew. Chemie Int. Ed.,* 2014, vol. 53, 6402-6406
- *Nat. Mater.,* 2015, vol. 14, 459-462
- *Adv. Mater.,* 2017
- *Nature Reviews Materials,* 2018, vol. 3, 18020
- *Nature,* 2012, vol. 492, 7428
- *Nat. Commun.,* 2015, vol. 6, 8476
- *Chem. Mater.,* 2017, vol. 29 (5), 1946
- *Adv. Mater.,* 2018, vol. 30, 1704961
- *Adv. Mater.,* 2017, 1605444-1, 1605444-54
- *Nature Photonics,* 2018, vol. 12, 98-104
- *Chem. Ber.,* 1972, vol. 105, 2686-93
- **E. MIYAMOTO ; Y. YAMAGUCHI ; M. MASAAKI.** *Electrophotography,* 1989, vol. 28, 364